# EUROPÄISCHE PATENTSCHRIFT

(11) **EP 2 317 618 B1**
(45) Veröffentlichungstag und Bekanntmachung des Hinweises auf die Patenterteilung: **30.04.2014**
(21) Anmeldenummer: 10013010.3
(22) Anmeldetag: 01.10.2010
(51) Int. Cl.: H02G 3/03, H02G 3/08, H02B 1/26, H05K 7/20

(54) **Elektrisches Installationseinbaugerät mit zumindest einer Wärme erzeugenden elektrischen Komponente**
Electric installation device with at least one electric component which generates heat
Appareil d'installation électrique doté d'au moins un composant électrique émettant de la chaleur

(30) Priorität: 29.10.2009 DE 102009051267; 07.08.2010 DE 102010033728
(43) Veröffentlichungstag der Anmeldung: 04.05.2011
(73) Patentinhaber: ABB AG, 68309 Mannheim (DE)
(72) Erfinder: Sahlmann, Hans-Peter, 58454 Witten (DE); Ewers, Manfred, Dipl.-Ing., 58239 Schwerte (DE)

(56) Entgegenhaltungen:
- DE-A1- 2 810 071
- DE-U1- 8 130 300
- DE-U1- 8 412 947
- DE-U1- 9 418 939

## Beschreibung

Die Erfindung betrifft ein elektrisches Installationseinbaugerät mit einem aus einem Gehäuseunterteil und einem Gehäuseoberteil bestehenden Kunststoffgehäuse, das einen Gehäuseraum umgibt, in dem zumindest eine Wärme erzeugende elektrische Komponente angeordnet ist, die mit mindestens einem Kühlkörper Wärme leitend verbunden ist, wobei das Kunststoffgehäuse Mittel zur Befestigung aufweist, mittels der es auf einer Hutschiene befestigbar ist.

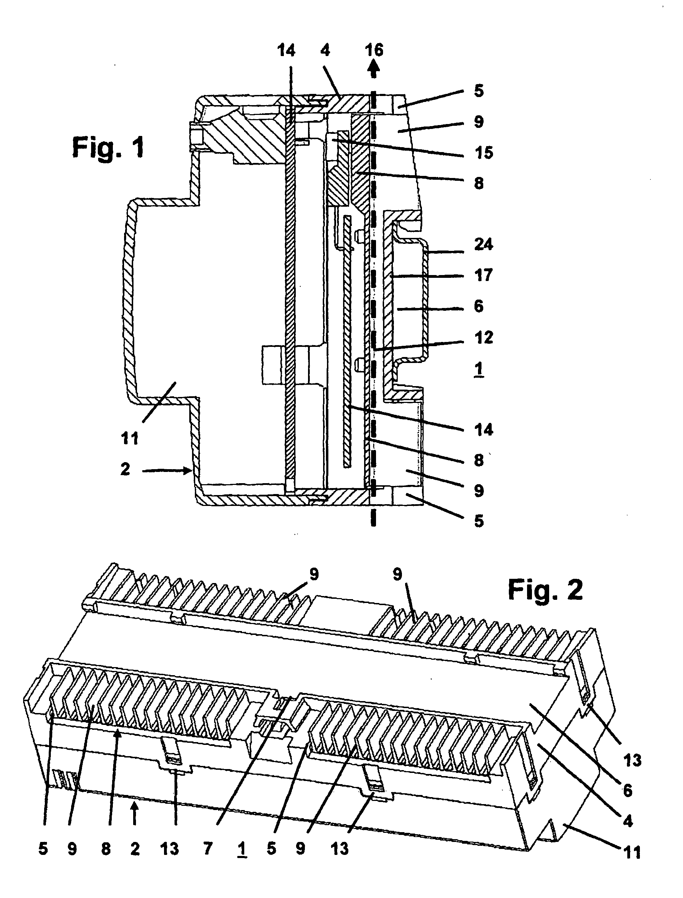

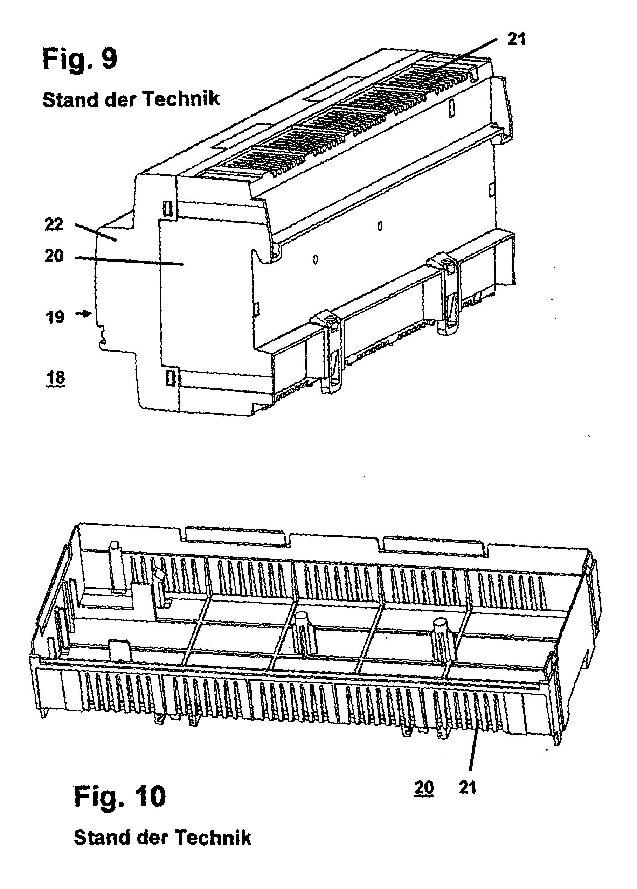

In Fig. 9 ist eine perspektivische Sicht auf die Rückseite eines elektrischen Installationseinbaugerätes gemäß dem allgemein bekannten Stand der Technik dargestellt. Das elektrische Installationseinbaugerät 18 weist ein aus einem Gehäuseunterteil 20 und einem Gehäuseoberteil 22 zusammengesetztes Kunststoffgehäuse 19 auf. Die Rückseite des Gehäuseunterteils 20 weist die erforderlichen Mittel auf, um eine Montage des elektrischen Installationseinbaugeräts 18 auf einer Hutschiene (siehe Ziffer 24 in Fig. 1) zu ermöglichen.

Problematisch sind dabei elektrische Installationseinbaugeräte 18 mit einer relativ hohen Leistungsaufnahme-1000 W und höher. In solchen Installationseinbaugeräten entsteht eine relativ hohe Verlustleitung in Form von Wärme, welche aus den Installationseinbaugeräten abgeführt werden muss, um eine Überhitzung und damit Zerstörung elektronischer Bauteile zu verhindern. Hierzu ist es allgemein üblich, im Gehäuseinnenraum angeordnete (innenliegende) Kühlkörper unmittelbar an den wärmeproduzierenden Baukomponenten anzubringen, wobei Lüftungsschlitze 21 im Gehäuseunterteil 20 eingebracht sind, um eine Luftzirkulation durch das Kunststoffgehäuse 19 und auf diese Weise die gewünschte Wärmeabfuhr (Wärmeabgabeleistung) aus dem Gehäuseinnenraum an die Außenatmosphäre (Außenluft) zu ermöglichen.

In Fig. 10 ist eine perspektivische Sicht auf ein Gehäuseunterteil 20 des Kunststoffgehäuses 19 gemäß dem allgemein bekannten Stand der Technik dargestellt, wobei insbesondere die Lüftungsschlitze von Interesse sind.

Der Erfindung liegt die Aufgabe zugrunde, ein elektrisches Installationseinbaugerät mit zumindest einer Wärme erzeugenden elektrischen Komponente anzugeben, welches eine erhöhte Wärmeabgabeleistung aufweist.

Diese Aufgabe wird in Verbindung mit den Merkmalen des Oberbegriffes erfindungsgemäß dadurch gelöst,
- dass das Gehäuseunterteil mindestens eine bodenseitigen Öffnung aufweist, durch welche der Kühlkörper mit seinen Kühlrippen derart ragt, dass die Wärme unmittelbar an die das Kunststoffgehäuse umgebende Umgebung abführbar ist und
- dass ein Luftkanal zwischen dem Kühlkörper und einer Rückwand des Gehäuseunterteils ausgebildet ist, welcher eine vertikale Luftströmung durch das Installationseinbaugerät von unten nach oben bewirkt und fördert.

Die mit der Erfindung erzielbaren Vorteile bestehen insbesondere darin, dass das elektrische Installationseinbaugerät einen erhöhten Wärmeaustausch ermöglicht, wodurch elektrische Installationseinbaugeräte mit höherer Leistung (und dementsprechend höherer möglicher Verlustleistung) entwickelt / eingesetzt werden können. Aufgrund der Tatsache, dass der Kühlkörper über seine Kühlrippen einen unmittelbaren Zugang zur Umgebungsluft hat, ist die Wärmeabfuhr wesentlich höher als bei Installationseinbaugeräten, bei denen der Kühlkörper lediglich im Gehäuseinnenraum untergebracht ist, d. h. es entfällt jegliche Beschränkung der Wärmeabgabe durch einen die Wärmeabfuhr behindernden / einschränkenden Gehäuseinnenraum. Im Gegensatz zu Gehäuseunterteilen, die vollständig aus elektrisch leitfähigem Metall gefertigt werden, bleibt beim vorgeschlagenen Installationseinbaugerät jedoch der Bereich um die Hutschiene herum vorteilhaft aus elektrisch isolierendem Kunststoff. Dadurch ergeben sich hinsichtlich der elektromagnetischen Verträglichkeit keine negativen Auswirkungen.

Eine vorteilhafte Ausgestaltung der Erfindung ist im Unteranspruch gekennzeichnet.

Die Erfindung wird nachstehend an Hand der in der Zeichnung dargestellten Ausführungsbeispiele näher erläutert. Es zeigen:
- Fig. 1: einen seitlichen Schnitt durch ein elektrisches Installationseinbaugerät (Reiheneinbaugerät REG),
- Fig. 2: eine perspektivische Sicht auf die Rückseite eines elektrischen Installati- onseinbaugerätes,
- Fig. 3: eine perspektivische Sicht auf die Rückseite eines Kühlkörpers,
- Fig. 4: eine perspektivische Sicht auf die Rückseite eines Gehäuseunterteils,
- Fig. 5: einen seitlichen Schnitt durch das Installationseinbaugerät mit Details zum Luftkanal,
- Fig. 6: einen seitlichen Schnitt durch das Installationseinbaugerät mit detaillierter Darstellung der Öffnungen (Lüftungsschlitze) für den Luftaustausch,
- Fig. 7: eine perspektivische Sicht auf die Rückseite eines Installationseinbauge- rätes mit Details zum Luftkanal,
- Fig. 8: eine perspektivische Sicht auf die Rückseite eines Installationseinbauge- rätes zur Erläuterung der Luftströmung,
- Fig. 9: eine perspektivische Sicht auf die Rückseite eines elektrischen Installati- onseinbaugerätes (Stand der Technik),
- Fig. 10: eine perspektivische Sicht auf ein Gehäuseunterteil (Stand der Technik).

In Fig. 1 ist ein seitlicher Schnitt durch ein elektrisches Installationseinbaugerät (Reiheneinbaugerät) dargestellt. Das auf einer Hutschiene 24 nach DIN 43880 montierte elektrische Installationseinbaugerät 1 weist ein aus Gehäuseunterteil 4 und Gehäuseoberteil 11 (z. B. über Nut / Feder-Verbindungsmittel) zusammengesetztes Kunststoffgehäuse 2 auf. Das Gehäuseunterteil 4 ist rückseitig mit einem gekapselten (elektrisch isolierten) Bereich 6 zur Montage der Hutschiene 24 versehen. Der gekapselte Bereich 6 umschließt die Hutschiene 24 (in elektrisch isolierender Weise) U-förmig.

Innerhalb des Installationseinbaugerätes 1 sind z. B. mehrere Leiterplatten 14 angeordnet, welche unter anderem zur Montage wärmeproduzierender Baukomponenten 15, z. B. Transistoren, dienen. Diese wärmeproduzierenden Baukomponenten 15 haben unmittelbaren thermischen Kontakt mit einem z. B. aus Aluminium bestehenden Kühlkörper 8, dessen Kühlrippen 9 über relativ große bodenseitige Öffnungen 5 des Gehäuseunterteils 4 nach außen geführt sind, d. h. unmittelbaren Zugang zur Umgebungsluft aufweisen.

Mit anderen Worten ist das Gehäuseunterteil 4 an mehreren Stellen soweit geöffnet, dass der Kühlkörper 8 + 9 zum Teil nach außen durchtauchen kann. Geometrisch ist das üblicherweise hinsichtlich seiner Haupt-Längsachse in horizontaler Position zu montierende Installationseinbaugerät 1 so ausgelegt, dass eine vertikale Luftströmung 16 das Installationseinbaugerät 1 von unten nach oben hindurch durchströmt. Diese Luftströmung 16 durchströmt insbesondere auch einen sich zwischen Kühlkörper 8 und der aus (elektrisch isolierendem) Kunststoffmaterial gebildeten Rückwand 17 des Gehäuseunterteils 4 ausbildenden Luftkanal 12. Durch den Luftkanal 12 wird quasi ein die Luftströmung 16 verstärkender "Kamineffekt" innerhalb des Kunststoffgehäuses 2 bewirkt.

In Fig. 2 ist eine perspektivische Sicht auf die Rückseite eines elektrischen Installationseinbaugerätes dargestellt. Es ist insbesondere zu erkennen, dass das Installationseinbaugerät 1 einen durch die bodenseitigen Öffnungen 5 nach außen geführten Kühlkörper 8 aufweist, dessen hochstehende Kühlrippen 9 aus dem Kunststoffgehäuse 2 "herausschauen". Es ist auch zu erkennen, dass Gehäuseunterteil 4 und Gehäuseoberteil 11 über mehrere Rastmittel 13 miteinander verbunden sind. Des Weiteren sind der gekapselte Bereich 6 zur Montage der Hutschiene sowie (üblicherweise federbeaufschlagte) Befestigungsmittel 7 zum Befestigen des Gerätes an / Lösen des Gerätes von der Hutschiene 24 dargestellt. Mit dem Begriff "gekapselt" soll verdeutlicht werden, dass die üblicherweise aus einem elektrisch leitfähigen Metall gebildete Hutschiene 24 keinerlei elektrischen Kontakt mit elektrisch leitfähigen Bauteilen des Installationseinbaugerätes 1, insbesondere auch nicht mit dessen (Aluminium-) Kühlkörper 8 respektive den von Außenluft umströmten Kühlrippen 9 hat.

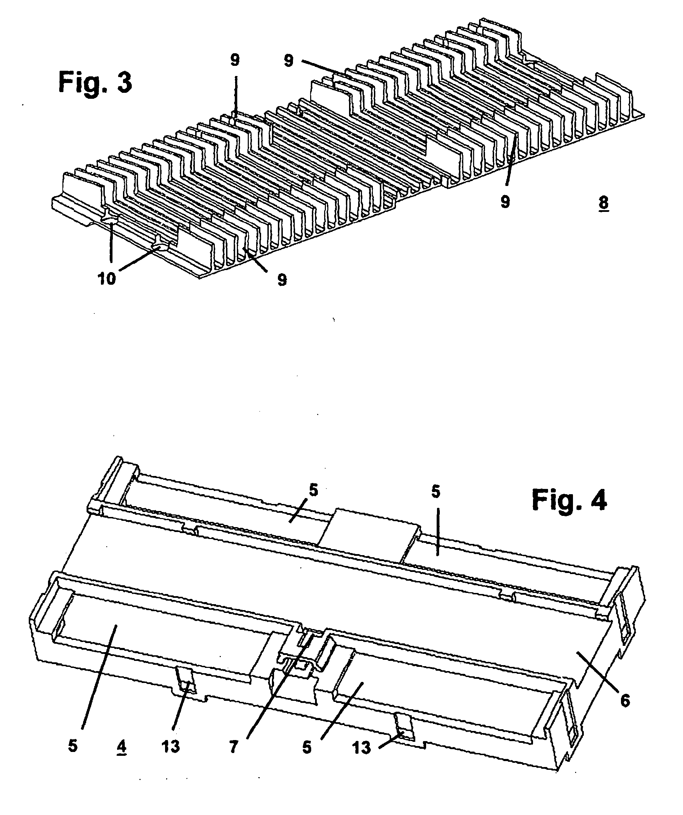

In Fig. 3 ist eine perspektivische Sicht auf die Rückseite eines Kühlkörpers dargestellt. Es sind insbesondere vier symmetrisch angeordnete, ausgeprägte Bereiche des Kühlkörpers 8 zu erkennen, welche mit hochstehenden Kühlrippen 9 versehen sind, die nach Montage durch die bodenseitigen Öffnungen 5 im Gehäuseunterteil 4 "tauchen". Die übrige Fläche des Kühlkörpers 8 weist nicht speziell bezeichnete Kühlrippen von geringerer Höhe auf.

In Fig. 4 ist eine perspektivische Sicht auf die Rückseite eines Gehäuseunterteils 4 dargestellt. Es sind insbesondere die vier vorstehend bereits mehrfach erwähnten relativ großen bodenseitigen Öffnungen 5 zum "Durchtauchen" des Kühlkörpers 8 respektive seiner hochstehenden Kühlrippen 9 zu erkennen, welche vom gekapselten Bereich 6 zur Montage der Hutschiene (elektrisch isolierend) getrennt sind. Des Weiteren sind Rastmittel 13 für die Verbindung mit dem Gehäuseoberteil und Befestigungsmittel 7 zum Befestigen an / Lösen von der Hutschiene 24 dargestellt.

Selbstverständlich ist es abweichend von der vorstehend erläuterten Ausführungsform auch möglich, das Gehäuseunterteil 4 mit weniger (z. B. einer, zwei oder drei) oder mehr bodenseitigen Öffnungen 5 zum Durchtauchen des Kühlkörpers 8 zu versehen.

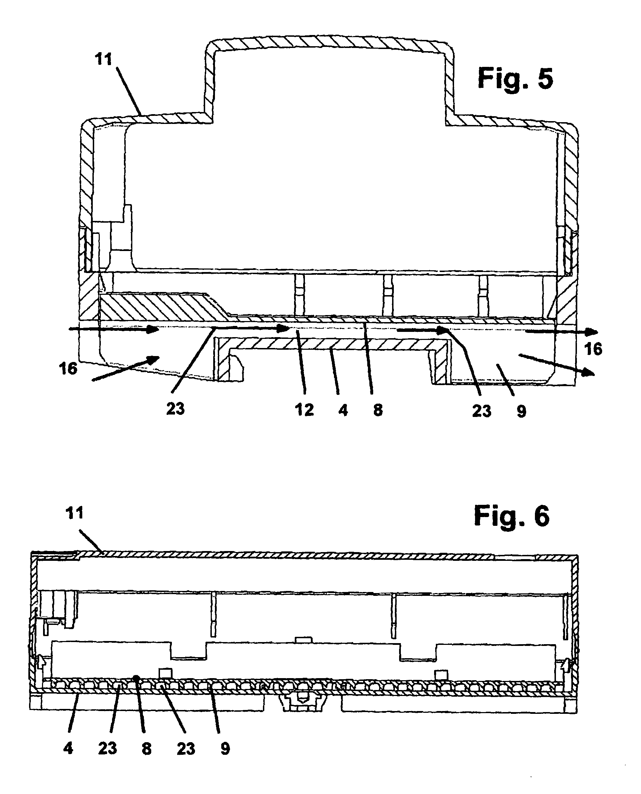

In Fig. 5 ist ein seitlicher Schnitt durch das Installationseinbaugerät mit Details zum Luftkanal dargestellt. Es sind der zwischen der Bodenplatte des Gehäuseunterteils 4 und dem Kühlkörper 8 ausgebildete Luftkanal 12 mit seinen Öffnungen 23 (Lüftungsschlitzen) für den Luftaustausch sowie die sich ergebende, mit Pfeilen skizzierte Luftströmung 16 durch das Installationseinbaugerät sowie die Kühlrippen 9 und das Gehäuseoberteil 11 gezeigt.

In Fig. 6 ist ein seitlicher Schnitt durch das Installationseinbaugerät mit detaillierter Darstellung der Öffnungen (Lüftungsschlitze) für den Luftaustausch dargestellt. Es sind die sich zwischen der Bodenplatte des Gehäuseunterteils 4, dem Kühlkörper 8 und den Kühlrippen 9 ausbildenden Öffnungen 23 (Lüftungsschlitze) für den Luftaustausch sowie das Gehäuseoberteil 11 gezeigt.

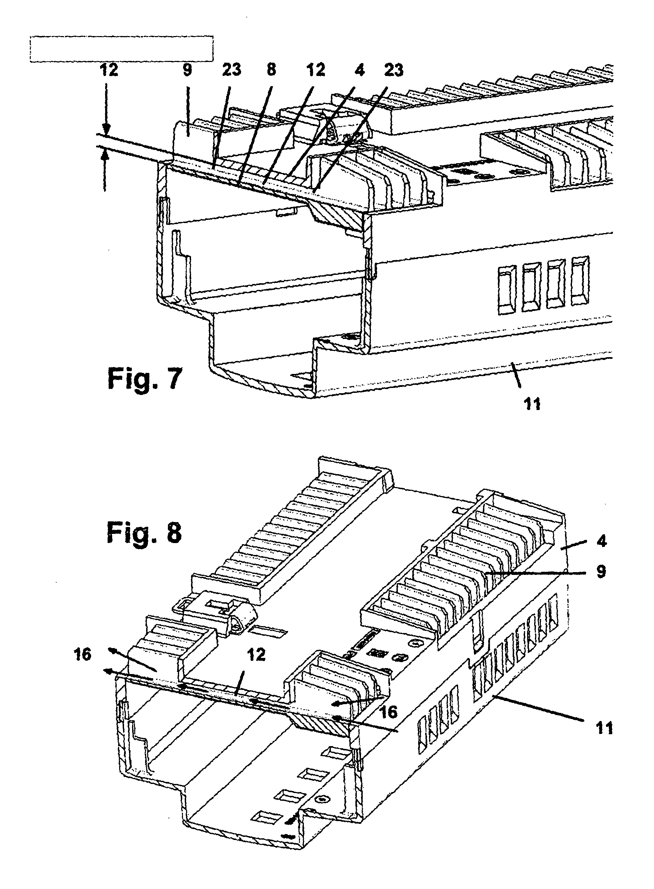

In Fig. 7 ist eine perspektivische Sicht auf die Rückseite eines Installationseinbaugerätes mit Details zum Luftkanal dargestellt. Die inneren und äußeren Gehäusekanten des Gehäuseunterteils 4 sind versetzt zueinander angeordnet, so dass sich hieraus im Zusammenspiel mit dem gegenüber der Bodenplatte des Gehäuseunterteils 4 beabstandet angeordnetem Kühlkörper 8 der Luftkanal 12 mit seinen Öffnungen 23 (Lüftungsschlitzen) für den Luftaustausch ergibt. Des Weiteren sind die Kühlrippen 9 des Kühlkörpers und das Gehäuseoberteil 11 bezeichnet.

In Fig. 8 ist eine perspektivische Sicht auf die Rückseite eines Installationseinbaugerätes zur Erläuterung der Luftströmung dargestellt. Die sich zwischen den Kühlrippen 9 und durch den Luftkanal 12 ausbildende Luftströmung 16 ist mit Pfeilen skizziert. Des Weiteren sind das Gehäuseunterteil 4 und das Gehäuseoberteil 11 bezeichnet.

### Bezugszeichenliste

- 1: Elektrisches Installationseinbaugerät (Reiheneinbaugerät)
- 2: Kunststoffgehäuse
- 3: -
- 4: Gehäuseunterteil
- 5: bodenseitige Öffnungen zum Durchtauchen des Kühlkörpers
- 6: gekapselter Bereich zur Montage einer Hutschiene
- 7: Befestigungsmittel zum Befestigen an / Lösen von der Hutschiene
- 8: Kühlkörper
- 9: Kühlrippen
- 10: Montagebohrungen
- 11: Gehäuseoberteil
- 12: Luftkanal
- 13: Rastmittel
- 14: Leiterplatte
- 15: wärmeproduzierende Baukomponente
- 16: Luftströmung durch das Installationseinbaugerät
- 17: Rückwand des Gehäuseunterteils 4
- 18: Elektrisches Installationseinbaugerät (gemäß dem Stand der Technik)
- 19: Kunststoffgehäuse
- 20: Gehäuseunterteil
- 21: Lüftungsschlitze
- 22: Gehäuseoberteil
- 23: Öffnungen (Lüftungsschlitze) für den Luftaustausch
- 24: Hutschiene

## Patentansprüche

1. Elektrisches Installationseinbaugerät (1) mit einem aus einem Gehäuseunterteil (4) und einem Gehäuseoberteil (11) bestehenden Kunststoffgehäuse (22), das einen Gehäuseraum umgibt, in dem zumindest eine Wärme erzeugende elektrische Komponente (15) angeordnet ist, die mit mindestens einem Kühlkörper (8) Wärme leitend verbunden ist, wobei das Kunststoffgehäuse (22) Mittel zur Befestigung aufweist, mittels der es auf einer Hutschiene (24) befestigbar ist, **dadurch gekennzeichnet,**
- **dass** das Gehäuseunterteil (4) mindestens eine bodenseitigen Öffnung (5) aufweist, durch welche der Kühlkörper (8) mit seinen Kühlrippen (9) derart ragt, dass die Wärme unmittelbar an die das Kunststoffgehäuse (22) umgebende Umgebung abführbar ist und
- **dass** ein Luftkanal (12) zwischen dem Kühlkörper (8) und einer Rückwand (17) des Gehäuseunterteils (4) ausgebildet ist, welcher eine vertikale Luftströmung (16) durch das Installationseinbaugerät (1) von unten nach oben bewirkt und fördert.

2. Installationseinbaugerät (1) nach Anspruch 1, **dadurch gekennzeichnet, dass** die mindestens eine bodenseitige Öffnung (5) des Gehäuseunterteils (4) derart angeordnet ist, dass ein gekapselter, elektrisch vom durchtauchenden Kühlkörper (8) respektive seinen Kühlrippen (9) isolierter Bereich (6) zur Montage der Hutschiene (24) verbleibt.

## Claims

1. Electrical installation device (1) with a plastic housing (22), which consists of a lower housing part (4) and an upper housing part (11) and surrounds a housing space in which there is arranged at least one heat-generating electrical component (15), which is connected in a heatconducting manner to at least one heat sink (8), the plastic housing (22) having means for fastening, by means of which it can be fastened on a top-hat rail (24), **characterized**
**in that** the lower housing part (4) has at least one bottom opening (5), through which the heat sink (8) protrudes with its cooling ribs (9) in such a way that the heat can be dissipated directly to the surroundings that surround the plastic housing (22) and
**in that** an air duct (12), which induces and promotes a vertical air flow (16) through the installation device (1) from the bottom upwards, is formed between the heat sink (8) and a rear wall (17) of the lower housing part (4).

2. Installation device (1) according to Claim 1, **characterized in that** the at least one bottom opening (5) of the lower housing part (4) is arranged in such a way that an encapsulated region (6) that is electrically insulated from the extending-through heat sink (8) or its cooling ribs (9) remains for the mounting of the top-hat rail (24).

## Revendications

1. Appareil d'installation électrique (1) comprenant un boîtier en plastique (22) constitué d'une partie inférieure de boîtier (4) et d'une partie supérieure de boîtier (11), lequel boîtier en plastique entoure un espace de boîtier dans lequel est disposé au moins un composant électrique (15) générant de la chaleur, lequel composant électrique est en liaison de conduction de chaleur avec au moins un corps de refroidissement (8), le boîtier en plastique (22) comprenant des moyens de fixation au moyen desquels il peut être fixé sur un profilé chapeau (24), **caractérisé**
- **en ce que** la partie inférieure de boîtier (4) comprend au moins une ouverture (5) du côté de la base, à travers laquelle ouverture le corps de refroidissement (8) fait saillie par ses ailettes de refroidissement (9) de telle sorte que la chaleur puisse être dissipée directement dans l'environnement entourant le boîtier en plastique (22) et
- **en ce qu'**un conduit d'air (12) est réalisé entre le corps de refroidissement (8) et une paroi arrière (17) de la partie inférieure de boîtier (4), lequel conduit d'air provoque et favorise un écoulement vertical d'air (16) du bas vers le haut à travers l'appareil d'installation électrique (1).

2. Appareil d'installation électrique (1) selon la revendication 1, **caractérisé en ce que** l'au moins une ouverture (5) du côté de la base de la partie inférieure de boîtier (4) est disposée de telle sorte qu'une région (6), encapsulée et isolée électriquement du corps de refroidissement traversant (8), respectivement de ses ailettes de refroidissement (9), pour le montage du profilé chapeau (24) demeure.
